Europäisches Patentamt

European Patent Office

Office européen des brevets

(11) Veröffentlichungsnummer: **0 151 458**
A2

(12) # EUROPÄISCHE PATENTANMELDUNG

(21) Anmeldenummer: 85100925.8

(22) Anmeldetag: 30.01.85

(51) Int. Cl.⁴: **H 01 L 27/15**
**H 01 L 25/04**

(30) Priorität: 02.02.84 DE 3403584

(43) Veröffentlichungstag der Anmeldung:
14.08.85 Patentblatt 85/33

(84) Benannte Vertragsstaaten:
AT BE CH DE FR GB IT LI LU NL SE

(71) Anmelder: Haberkern, Ottmar
Reuchlinstrasse 24
D-6200 Wiesbaden(DE)

(71) Anmelder: Kahl, Horst
Kirchstrasse 13
D-6148 Heppenheim 5(DE)

(72) Erfinder: Haberkern, Ottmar
Reuchlinstrasse 24
D-6200 Wiesbaden(DE)

(72) Erfinder: Kahl, Horst
Kirchstrasse 13
D-6148 Heppenheim 5(DE)

(54) Bildplatte für flimmer- und rauschfreie Farbbildwiedergabe.

(57) Es wird eine Einrichtung beschrieben, die zur elektr. flimmer- und rauschfreien Wiedergabe von Fernsehbildern dient. Diese wird mit Lumineszenz- oder Leuchtdiodenstreifen, die auf einer geeigneten Trägerplatte aufgebracht sind, erreicht. Diese Bildplatte wird nach Anspruch 1 dadurch gekennzeichnet, daß das Bauelement in jeder Form und Größe hergestellt werden kann, und welches in der Kommunikations- und Fernsehtechnik verwendet werden sollen. Außerdem soll die Bildplatte in Videokombinationen, Bildtelefonen, Computarn und Fernsehspielgeräten verwendet werden.

Bild 1

EP 0 151 458 A2

## Bildplatte für flimmer- und rauschfreie Farbbildwiedergabe

Alle bisher bekannten Verfahren zur Bildwiedergabe haben folgende Nachteile:

1. Voluminöse schwer herzustellende Vakuumbildröhren
2. Zu schlechte Auflösungen wegen zu wenigen Bildpunkten
3. Das zu teure Herstellungsverfahren von blauen Leuchtdioden
4. verschlierte Wiedergabe bei Flüssigkeitsschirmen (Flüssigkristalle)
5. Ungleiche Lichtausbeute bei verschiedenen Leuchtdioden und Luminiszensstoffen.

Bei unserer Erfindung greifen wir auf Verfahren zurück, die mit der heutigen Technik zu verwirklichen sind.

1. Version: Aufgedruckte Leuchtbahnen, bei denen durch ein elektrisches Wechselfeld Luminiszens erzeugt wird. .

2. Version: Aufgedrucktes oder durch andere chemische oder elektromechanische Verfahren aufgebrachtes amorphes Siliziummaterial in Streifenform zur Herstellung von Leuchtdioden.

3. Version: Aufbringen von Siliziumkristallen auf einer Keramikplatte, auf die vorher eine Leitungsstruktur aufgedampft wurde und die durch nachträgliche Dotierung zu Leuchtdioden gezüchtet werden. Durch Auf-

0151458

drucken oder Aufdampfen von Querverbindungen würde eine sogenannte Kreuzschienenplatte entstehen, wobei jede Kreuzung einem Leuchtpunkt entspricht. Da wir aber zur Farbwiedergabe die drei Grundfarben rot, grün und blau benötigen, so müssen diese spaltenförmigen Diodenzeilen am Schluß noch mit einer farbkonstanten Filterschicht streifenweise überdruckt werden.

An den Enden der Spalten und Zeilenleitungen wurden vorher in die Keramik- oder Trägerplatte (aus geeignetem Material) mit einem Laser Kanäle eingebracht, die auf dem Prinzip der durchkontaktierten Leiterplatte metallisiert wurden und die auf der Rückseite in ein aufgedrucktes Leiternetz mit Bonderpunkten auslaufen, auf die entsprechende Halbleiterschaltungen in Chipform mit den üblichen Verfahren aufgebracht werden.

Die elektrische Wiedergabe des Bildes geht folgendermaßen vor sich.

Die Farb- und Helligkeitsinformation wird aus der normalen Fernsehnorm in digitale Information verarbeitet und in einen Speicher übernommen, der über geeignete Ausgabeschaltungen sämtliche Zeilen parallel und nicht in serieller Form ausschreibt; dadurch ergibt sich ein extrem flimmer- und rauschfreies Bild.

-3-

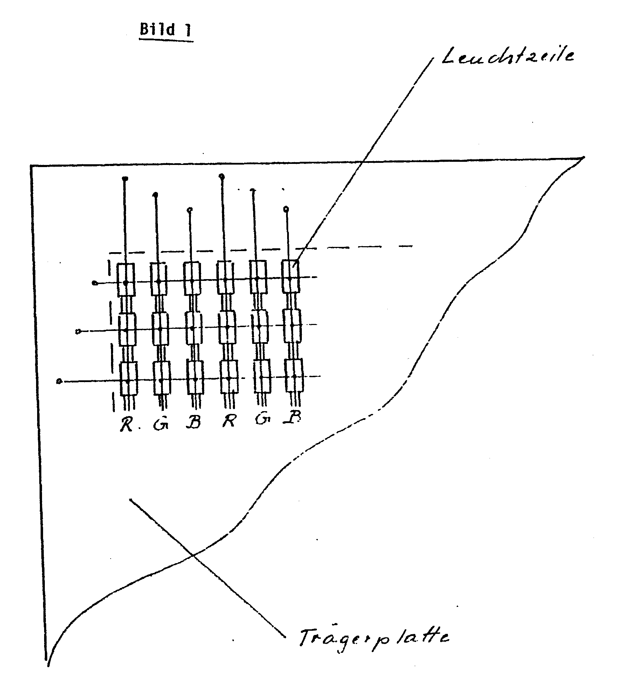

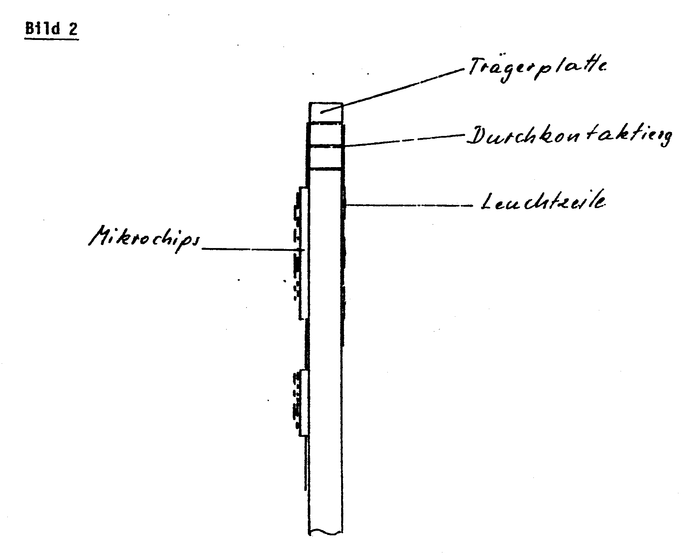

## Patentansprüche

1. Bildplatte zur elektrischen flimmer- und rauschfreien Wiedergabe von Fernsehbildern, dadurch gekennzeichnet, daß Lumineszens oder Leuchtdiodenstreifen auf einer Trägerplatte über das beschriebene und skizzierte Verfahren wiedergegeben werden können.

2. Bildplatte nach Anspruch 1 dadurch gekennzeichnet, daß das Bauelement in jeder Form und Größe hergestellt werden kann und insbesondere in der Kommunikation und Fernsehtechnik verwendet werden soll.

3. Bildplatte nach Anspruch 1 und 2 dadurch gekennzeichnet, daß sie als Monitor in Videokombination und Bildtelefonen verwendet werden soll.

**Bild 1**

Leuchtzeile

R . G B R G B

Trägerplatte

Bild 2

Trägerplatte

Durchkontaktierg

Leuchtzeile

Mikrochips